# EUROPEAN PATENT APPLICATION

(11) **EP 4 290 989 A1**
(43) Date of publication of application: **13.12.2023**
(21) Application number: 23178482.8
(22) Date of filing: 09.06.2023
(51) Int. Cl.: H05K 5/02

(54) **CONTAINMENT STRUCTURE FOR A CONTROL UNIT OF AN APPLIANCE**

(30) Priority: 10.06.2022 US 202217837147
(71) Applicant: Whirlpool Corporation, Benton Harbor, MI 49022 (US)
(72) Inventor: MARICAR, Mohamed Fahadh Abdoulazidou, Benton Harbor 49022 (US)
(74) Representative: PGA S.p.A.

(57) **Abstract**

An appliance (10) having a cabinet (12), a control unit (62) and a containment structure (176). The cabinet (10) defining an interior (14). The control unit (62) being provided within the interior (14) of the cabinet (10) and having a housing defining a periphery. The containment structure (176) provided around the periphery of the control unit (62) and having at least one opening (184).

## Description

### TECHNICAL FIELD

This disclosure generally relates to a containment structure for a control unit of an appliance.

### BACKGROUND

An appliance can be any suitable device used in a commercial, industrial, or residential setting to perform a function. For example, an appliance can be a laundry machine, a dishwasher, a microwave, an oven, an air conditioner, or the like. The appliance can utilize an Appliance Control Unit (ACU) to control at least one function of the appliance. For example, the ACU can be communicatively coupled to a motor and a heater of a laundry machine and send a command to the laundry appliance to operate the motor and heater according to an operation of the laundry machine. The ACU can include one or more components such as a memory or a processor configured to receive and store information, and to process, generate and send commands.

During operation of the appliance, the ACU can receive, transmit and process information. This operation results in the ACU generating a heat. Traditionally, the ACU is encased within a rigid housing (e.g., a plastic housing) that includes one or more openings. At least a portion of the openings are sized to receive one or more wires connected to the ACU, while another portion of the openings are sized as thermal exhaust ports. Without the thermal exhaust ports, the ACU would overheat and cease to function. The heat generated by the ACU, however, can attract organic material. For example, pests (e.g., gnats, cockroaches, moths, spiders, ants, etc.) are attracted to the heat generated by the ACU. The pests, in some instances, will deposit organic material (e.g., feces, food, eggs, moltings, or pest bodies) within the ACU or along the openings. This deposit of organic material ultimately results in additional insulation within the or along the housing. The additional insulation ultimately results in the thermal exhaust ports not functioning as intended and heat being trapped within the housing. This, in turn, results in the ACU overheating which can greatly reduce the life of the ACU with respect to an ACU that does not include the additional insulation from pests. The ACU can be replaced, however, this is a timely and costly process and the appliance cannot be used until the ACU is replaced.

### BRIEF SUMMARY

In one aspect, the present disclosure relates to an appliance comprising a cabinet defining an interior, a control unit provided within the interior and having at least one port configured to receive a wire, and a housing defining a periphery of the control unit, and a containment structure provided around the periphery of the control unit, the containment structure having at least one opening corresponding to the at least one port, wherein the at least one opening is sized to accept the wire and form a seal around a respective portion of the wire when the wire is received within the at least one port.

In another aspect, the present disclosure relates to an appliance comprising a control unit having a housing defining a periphery, and a containment structure provided around the periphery of the control unit, the containment structure including an outer wall having a mesh of less than or equal to 1 millimeter.

In another aspect, the present disclosure relates to a containment structure for a control unit of an appliance, the control unit having a housing defining a periphery, the containment structure comprising an outer wall defining an interior and having a mesh, at least one opening formed along a portion of the outer wall, and a closure provided along the outer wall, the closure being movable between an open position and a closed position to provide selective access to the interior.

### BRIEF DESCRIPTION OF THE DRAWINGS

A full and enabling disclosure of the present description, including the best mode thereof, directed to one of ordinary skill in the art, is set forth in the specification, which refers to the appended FIGS., in which
FIG. 1 is a schematic illustration of an appliance having a cabinet defining an interior and a control unit provided within the interior according to an aspect of the present disclosure.
FIG. 2 is a schematic illustration of the control unit of FIG. 1, further illustrating a memory and a processor of the control unit according to an aspect of the present disclosure.
FIG. 3 is a schematic illustration of a control unit suitable for use as the control unit of FIG. 1, further including a containment structure provided around the control unit according to an aspect of the present disclosure.

### DETAILED DESCRIPTION

Aspects of the disclosure relate to an appliance including a cabinet (e.g., a housing) defining an interior. A control unit can be provided within the interior. The control unit can be communicatively coupled to at least a portion of the appliance. The control unit can be configured to receive, transmit, generate and process information related to the function of the appliance. A containment structure can be provided around a periphery of the control unit.

The containment structure can be retrofittable to the appliance (e.g., provided or placed around the control unit on an existing appliance). The containment structure is sized to stop an ingress of pests, organic material, or organic material from pests into or around the periphery of the control unit. The containment structure can be provided around any suitable control unit of any suitable appliance in a commercial, residential, industrial or retail environment. As a non-limiting example, the appliance can be, but is not limited to, a laundry treating appliance (e.g., a dryer, a washer, or a combination washer/dryer), a microwave, an air conditioner, a heater, a refrigerator, a stove, a dishwasher, a coffee machine, or the like.

While "a set of" various elements will be described, it will be understood that "a set" can include any number of the respective elements. It will be yet further understood that the "a set" can include only one element. Also, as used herein, while elements or components can be described as "sensing" or "measuring" a respective value, data, function, or the like, sensing or measuring can include determining a value indicative of or related to the respective value, data, function, or the like, rather than directly sensing or measuring the value, data, function, or the like, itself. The sensed or measured value, data, function, or the like, can further be provided to additional components. For instance, the value can be provided to a controller module or processor, and the controller module or processor can perform processing on the value to determine a representative value or an electrical characteristic representative of said value, data, function, or the like.

As used herein, a "system" or a "controller module" can include at least one processor and memory. Non-limiting examples of the memory can include Random Access Memory (RAM), Read-Only Memory (ROM), flash memory, or one or more different types of portable electronic memory, such as discs, Digital Versatile Discs (DVDs), Compact Disc - Read Only Memory (CD-ROMs), etc., or any suitable combination of these types of memory. The processor can be configured to run any suitable programs or executable instructions designed to carry out various methods, functionality, processing tasks, calculations, or the like, to enable or achieve the technical operations or operations described herein. The program can include a computer program product that can include machine-readable media for carrying or having machine-executable instructions or data structures stored thereon. Such machine-readable media can be any available media, which can be accessed by a general purpose or special purpose computer or other machine with a processor. Generally, such a computer program can include routines, programs, objects, components, data structures, algorithms, etc., that have the technical effect of performing particular tasks or implement particular abstract data types.

Reference will now be made in detail to aspects of the disclosure, one or more non-limiting examples of which are illustrated in the FIGS. Each example is provided by way of explanation of the disclosure, not limitation of the disclosure. In fact, it will be apparent to those skilled in the art that various modifications and variations can be made in the present disclosure without departing from the scope or spirit of the disclosure. Thus, it is intended that the present disclosure covers such modifications and variations as come within the scope of the appended claims and their equivalents.

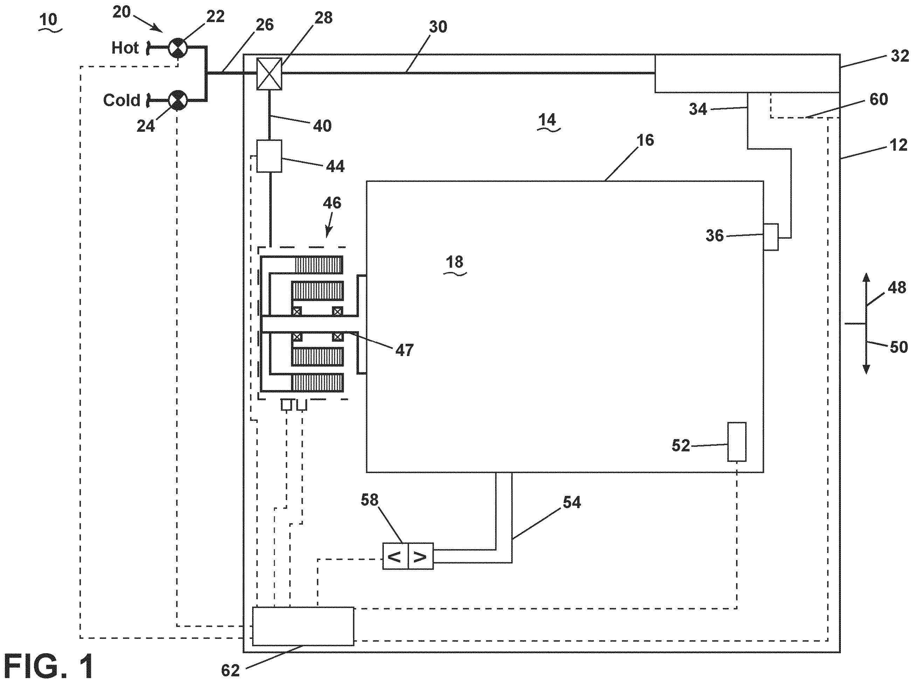

FIG. 1 is a schematic cross-sectional view of an appliance 10. As illustrated, the appliance 10 is a laundry treating appliance, however, it will be appreciated that the appliance 10 can be any suitable commercial, residential, industrial or retail appliance. The appliance 10 can be any appliance which performs an automatic cycle of operation to clean, treat, cook, brew, warm, cool or otherwise effect items placed therein. In terms of the appliance 10 being the laundry treating appliance, non-limiting examples include a horizontal or vertical axis clothes washer; a combination washing machine and dryer; a tumbling or stationary refreshing/revitalizing machine; an extractor; a non-aqueous washing apparatus; and a revitalizing machine.

The appliance 10 can include a cabinet 12 which defines a housing having an interior 14. The cabinet 12 can be a housing having a chassis and/or a frame, to which decorative panels can or cannot be mounted, defining the interior 14 enclosing component typically found in conventional appliances (e.g., motors, pumps, fluid lines, controls, sensors, transducers, and the like). A drum 16 is dynamically suspended within the cabinet 12. The drum 16 can define a treating chamber 18 where clothing articles or other items are washed and/or dried.

The appliance 10 can further comprise a washing circuit which can include a liquid supply system for supplying water to the appliance 10 for use in treating laundry during a cycle of operation. The liquid supply system can include a source of water, such as a household water supply 20, which can include separate valves 22 and 24 for controlling the flow of hot and cold water, respectively. Water can be supplied through an inlet conduit 26 directly to the interior 14 of the appliance 10 (e.g., the drum 16) by controlling the diverter valve 28. The diverter valve 28 can selectively direct a flow of liquid to one or both of two flow paths. Water from the household water supply 20 can flow through the inlet conduit 26 to the first diverter valve 28 which can direct the flow of liquid to a supply conduit 30.

The appliance 10 can include a dispensing system for dispensing treating chemistry to the treating chamber 18 for use in treating the load of laundry according to a cycle of operation. The dispensing system can include a treating chemistry dispenser 32 which can be a single dose dispenser, a bulk dispenser, or an integrated single dose and bulk dispenser and is fluidly coupled to the treating chamber 18. The treating chemistry dispenser 32 can be configured to dispense a treating chemistry directly to the drum 16 or mixed with water from the liquid supply system through a dispensing outlet conduit 34. The dispensing outlet conduit 34 can include a dispensing nozzle 36 configured to dispense the treating chemistry into the drum 16 in a desired pattern and under a desired amount of pressure.

Non-limiting examples of treating chemistries that can be dispensed by the dispensing system during a cycle of operation include one or more of the following: water, enzymes, fragrances, stiffness/sizing agents, wrinkle releasers/reducers, softeners, antistatic or electrostatic agents, stain repellants, water repellants, energy reduction/extraction aids, antibacterial agents, medicinal agents, vitamins, moisturizers, shrinkage inhibitors, and color fidelity agents, and combinations thereof.

The appliance 10 can include a sump formed by a sump conduit 54 that can fluidly couple the lower portion of the treating chamber 18 to a pump 58. The pump 58 can direct liquid to a drain conduit (not illustrated), which can drain the liquid from the appliance 10, or to a recirculation conduit (not illustrated) that can direct the liquid from the recirculation conduit into the drum 16.

The appliance 10 can include a heating system which can include one or more devices for heating laundry and/or liquid supplied to the drum 16, such as a steam generator 44. Liquid from the household water supply 20 can be provided to the steam generator 44 through the inlet conduit 26 by controlling the first diverter valve 28 to direct the flow of liquid to a steam supply conduit 40. Steam generated by the steam generator 44 can be supplied to the drum 16 through a steam outlet conduit (not illustrated).

The appliance 10 can also includes a drive system for rotating the drum 16 within the interior 14. The drive system can include a motor 46, which can be directly coupled with the drum 16 through a drive shaft 47 to rotate the drum 16 about a rotational axis during a cycle of operation. The motor 46 can be any suitable motor such as, but not limited to, a brushless permanent magnet (BPM), an induction motor or a permanent split capacitor (PSC) motor, or the like.

The appliance 10 can also include a control system for controlling the operation of the appliance 10 to implement one or more cycles of operation. The control system can include a control unit 62 located within the cabinet 12 and a user interface 60 that is operably coupled with the control unit 62. The user interface 60 can include one or more knobs, dials, switches, displays, touch screens and the like for communicating with the user, such as to receive input and provide output. The user can enter different types of information including, without limitation, cycle selection and cycle parameters, such as cycle options.

The control unit 62 can be provided within the interior 14 of the cabinet 12. As a non-limiting example, the appliance 10 can be split into a gravitational upper half 48 and a gravitational lower half 50. The control unit 62 can be provided within the gravitational lower half 50. The control unit 62 can be placed within the interior 14. Alternatively, the control unit 62 can be operably coupled to a portion of the appliance 10 such that it lays within the interior. As a non-limiting example, the control unit 62 can be coupled through any suitable method (e.g., welding, bolting, adhesives, etc.) to an interior portion of the cabinet 12.

The control unit 62 can be further defined as an Appliance Control Unit (ACU) for the appliance 10. The control unit 62 can include the machine controller and any additional controllers provided for controlling any of the components of the appliance 10. For example, the control unit 62 can include the machine controller and a motor controller. Many known types of controllers can be used for the control unit 62. It is contemplated that the controller is a microprocessor-based controller that implements control software and sends/receives one or more electrical signals to/from each of the various working components to affect the control software. As an example, proportional control (P), proportional integral control (PI), and proportional derivative control (PD), or a combination thereof, a proportional integral derivative control (PID control), can be used to control the various components.

The control unit 62 can also be coupled with one or more sensors 52 provided in one or more of the systems of the appliance 10 to receive input from the sensors. Non-limiting examples of sensors 52 that can be communicably coupled with the control unit 62 include: a temperature sensor, a moisture sensor, a weight sensor, a chemical sensor, a position sensor and a motor torque sensor, which can be used to determine a variety of system and characteristics, such as load inertia or mass.

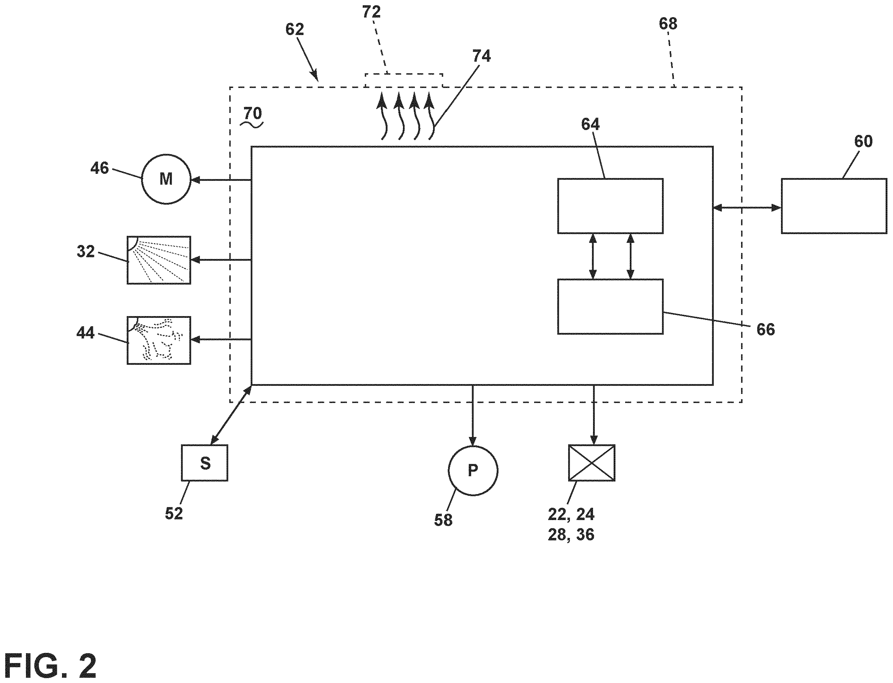

FIG. 2 is a schematic illustration of the control unit 62 of FIG. 1. The control unit 62 can be provided with a memory 64 and a central processing unit (CPU) 66. The memory 64 can be used for storing the control software that is executed by the CPU 66 in completing a cycle of operation using the appliance 10 and any additional software. Examples, without limitation, of cycles of operation for the appliance 10 being the laundry treating appliance include: wash, heavy duty wash, delicate wash, quick wash, pre-wash, refresh, rinse only, and timed wash. The memory 64 can also be used to store information, such as a database or table, and to store data received from one or more components of the appliance 10 that can be communicably coupled with the control unit 62. The database or table can be used to store the various operating parameters for the one or more cycles of operation, including factory default values for the operating parameters and any adjustments to them by the control system or by user input.

The control unit 62 can be operably coupled with one or more components of the appliance 10 for communicating with and controlling the operation of the component to complete a cycle of operation. For example, the control unit 62 can be operably coupled with the motor 46, the pump 58, the user interface 60, the treating chemistry dispenser 32, the steam generator 44, the sensor 52, the valves 22, 24, the dispensing nozzle 36, the diverter valve 28, or any other suitable portion of the appliance 10.

The control unit 62 can include a housing 68 defining a periphery of the control unit 62. The housing 68 can be any suitable housing. As a non-limiting example, the housing 68 can be a plastic housing. The housing 68 can define an interior 70, which a remaining portion of the control unit 62 (e.g., the memory 64 and the CPU 66) can be provided within.

During operation of the appliance 10, the control unit 62 can receive, transmit, generate and process information from any suitable portion of the appliance 10 related to the function of the appliance 10. This process or function of the control unit 62 generates a heat 74. The housing 68 can include at least one thermal vent 72 to allow the heat 74 to pass through the housing 68. This ensures that the heat 74 is not trapped within the interior 70 of the housing 68. This ultimately ensures that the control unit 62 will not overheat. If the control unit 62 overheats, the control unit 62 will not be able to function as intended, thus requiring a new appliance 10 or a new control unit 62 to be purchased and installed.

One drawback of this configuration, however, is that the heat 74 attracts pests as the pests will want to nest, molt, eat or mate near a heat source. Over time, the pests will deposit organic material in or around the housing 68 (e.g., in or around the thermal vent 72), which in turn acts as insulation. This organic material ultimately blocks the heat 74 from exiting the housing 68, thus resulting in the control unit 62 being prone to overheating and failing.

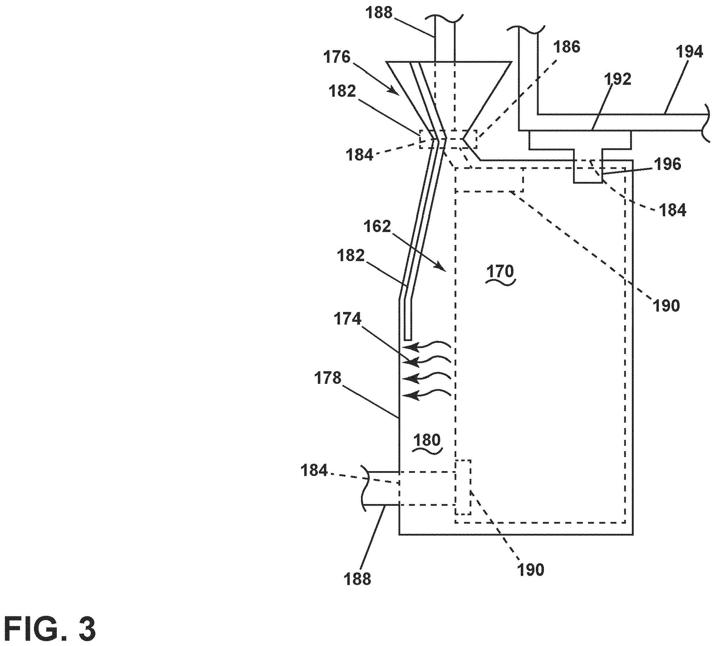

FIG. 3 is a schematic illustration of an exemplary control unit 162 suitable for use as the control unit 62 of FIG. 1. The control unit 162 is similar to the control unit 62, therefore, like parts will be identified with like numerals increased to the 100 series, with it being understood that the description of the like parts of the control unit 62 applies to the control unit 162 unless otherwise noted.

The control unit 162 can include a housing (not illustrated) defining an interior 170. The housing and the control unit 162 can take any suitable shape, size, or form, thus the control unit 162 is illustrated in phantom lines. The phantom lines of the control unit 162 illustrate a periphery of the control unit 162. The control unit 162 can be communicatively coupled to any suitable portion of an appliance (not illustrated) that the control unit 162 is provided within. At least one wire 188 can communicatively couple the control unit 162 to at least one portion of the appliance. The control unit 162 can include at least one port 190 configured to receive at least one wire 188. As illustrated, two wires 188 can be communicatively coupled to two separate ports 190 of the control unit 162. It will be appreciated that there can be any number of wires 188 or ports 190. Additional other structure can be provided along the control unit 162. As a non-limiting example, a caddy 192 can be operatively coupled to a portion of the control unit 162. As a non-limiting example, the caddy 192 can include a projection 196, which can be operatively coupled to a portion of the housing. The caddy 192 can be configured to receive a portion of a hose 194 or wire. The caddy 192 can be used to position various portions of the appliance (e.g., the hose 194 or wire 188) within the interior of the appliance.

A containment structure 176 can be provided around the periphery of control unit 162. The containment structure 176 can include an outer wall 178 defining an interior 180. The interior 170 of the control unit 162 can be provided within the interior 180 of the containment structure 176.

The outer wall 178 can include at least one opening 184. The at least one opening 184 can be sized to accept or fit around a corresponding portion of the appliance that is coupled to a portion of the control unit 162. As a non-limiting example, the containment structure 176 can include a plurality of openings 184 sized to fit around or otherwise accept the at least one wire 188 and the projection 196 of the caddy 192. It will be appreciated, however, that the containment structure 176 can include any suitable opening 184 sized to fit around or accept any suitable portion of the appliance.

A closure 182 can be provided along a portion of the containment structure 176. The closure 182 can be any suitable element or device that is configured to close or otherwise seal a portion of the containment structure 176. As a non-liming example, the closure 182 can be a cinch, zipper or an adhesive. The closure 182 can be selectively moveable between an opened and a closed position to provide selective access to the interior 180 of the containment structure 176.

The closure 182 can allow for the containment structure to be retrofittable to around the periphery of the control unit 162. As a non-limiting example, the closure 182 can be opened and the at least one opening 184 can be fit around the respective portions (e.g., the at least one wire 188 and the projection 196 of the caddy 192) of the appliance. Alternatively, the respective portions of the of the appliance can be inserted through the at least one opening 184. Once inside of the containment structure 176 (e.g., once inside of the interior 180 of the containment structure 176), the closure can be moved to a closed position such that the interiors 180 of the containment structure 176 cannot be accessed without opening the closure 182.

The at least one opening 184 can be sized to seal against a receptive portion of the appliance. It is contemplated that the at least one opening 184 can be sized such that a gap between the at least one opening 184 and a respective portion of the appliance is formed that is no greater than 1 millimeter (mm). The sizing of the gap between the at least one opening 184 and the respective portion of the appliance can be any suitable size, however, it is contemplated that the gap can be sized to ensure that pests or organic material from pests cannot pass through the gap. In some instances, the gap may be larger than 1 mm or a preferred size. In such an instance, an auxiliary closure 186 can be used to reduce the gap to the preferred size. The auxiliary closure 186 can be any suitable closure element. As a non-limiting example, the auxiliary closure 186 can be, but is not limited to, a tie, a clamp, an adhesive, an elastic material, or the like.

The outer wall 178 of the containment structure 176 can be any suitable material. As a non-limiting example, the outer wall 178 can be a mesh or fabric. As a non-limiting example, the outer wall 178 can be a nylon mesh or a woven fabric. In any case, the outer wall 178 can include a plurality of openings formed within the material. These openings formed within the material are less than or equal to 1 mm. As a non-limiting example, the outer wall 178 can be a mesh that is less than or equal to 1 mm. The openings of the material can be any suitable size. The openings of the material, like the gap of the at least one opening 184, can be sized to limit or completely stop the ingress of pests or organic material from pests into the interior 180, which ultimately stops the ingress of pests or organic material around or into the control unit 162.

During operation, the control unit 162 can generate a heat 174, which can permeate into the interior 180 of the containment structure 176. The containment structure 176 can be made of a breathable material. In other words, the containment structure 176 can be made of a material that allows for the heat 174 to dissipate through the containment structure 176. This, in turn, ensures that that heat 174 does not get trapped within the interior 180 of the containment structure 176, which ultimately ensures that the control unit 162 does not overheat.

Benefits of the present disclosure include a containment structure that is breathable while still limiting the ingress of pests and organic material from pests when compared to a conventional containment structure. For example, the conventional containment structure can be a housing surrounding the control unit that is made of a solid and/or rigid material. In order to allow for heat to dissipate through the conventional containment structure, thermal vents are traditionally used. These thermal vents, however, can become clogged with organic material from pests or be sized too large such that pests can get into an interior of the conventional containment structure. This, in turn, means that pests and/or organic material from pests can still get into the control unit and heat from the control unit can become trapped within the interior of the conventional containment structure, thus causing the control unit to overheat. The containment structure as described herein, however, includes an outer wall formed of a breathable material and ensures that no gaps or openings greater than 1 mm or a preferred size are formed. This, in turn, means that heat from the control unit can escape through the containment structure but pests and organic material from pests cannot get into an interior of the containment structure and thus cause the control unit to overheat. This ultimately increases the efficiency of the containment structure when compared to the conventional containment structure and further increases the lifespan of the control unit when compared to the conventional control unit.

Further benefits of the present disclosure include a more versatile appliance when compared to a conventional appliance. For example, as described above, conventional appliances include a control unit in which pests and/or organic material can get into and around. One way to avoid this happening is for the customer or user of the appliance to position the appliance within an environment without pests or to otherwise remove the pests from the environment. The removal of pests is costly and time consuming, while the positioning of the appliance may not be the preferred placement of the appliance. In other words, the environment that the user wants to position the appliance may have too many pests. The appliance as described herein, however, includes the control unit with the containment structure provided around it. This, in turn, means that the user of the appliance can position the appliance within their preferred environment (e.g.., balcony, kitchen, bathroom, etc.) and not have to worry about the pests within the environment from getting into the appliance. As such, the appliance as described herein is more versatile in that it can be provided within any suitable environment when compared to the conventional appliance. Further, as the user does not have to worry about the pests, the user does not need to remove the pests from the environment in order for the appliance to function. This, in turn, greatly reduces the costs associated with installing the appliance when compared to the conventional appliance as the user does not have to worry about removing the pests from the environment.

To the extent not already described, the different features and structures of the various aspects can be used in combination with each other as desired, or can be used separately. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described.

While the present disclosure has been specifically described in connection with certain specific aspects thereof, it is to be understood that this is by way of illustration and not of limitation. Reasonable variation and modification are possible within the scope of the forgoing disclosure and drawings without departing from the spirit of the present disclosure. Hence, specific dimensions and other physical characteristics relating to the aspects disclosed herein are not to be considered as limiting, unless expressly stated otherwise.

Further aspects of the invention are provided by the subject matter of the following clauses:

An appliance comprising a cabinet defining an interior, a control unit provided within the interior and having at least one port configured to receive a wire, and a housing defining a periphery of the control unit, and a containment structure provided around the periphery of the control unit, the containment structure having at least one opening corresponding to the at least one port, wherein the at least one opening is sized to accept the wire and form a seal around a respective portion of the wire when the wire is received within the at least one port.

An appliance comprising a control unit having a housing defining a periphery, and a containment structure provided around the periphery of the control unit, the containment structure including an outer wall having a mesh of less than or equal to 1 millimeter.

A containment structure for a control unit of an appliance, the control unit having a housing defining a periphery, the containment structure comprising an outer wall defining an interior and having a mesh, at least one opening formed along a portion of the outer wall, and a closure provided along the outer wall, the closure being movable between an open position and a closed position to provide selective access to the interior.

The appliance of any preceding clause, wherein the containment structure is selectively receivable around the control unit.

The containment structure of any preceding clause, wherein the closure is a zipper.

The appliance of any preceding clause, wherein the containment structure includes an outer wall having a mesh and defining an interior.

The appliance of any preceding clause, wherein the mesh is less than or equal to 1 millimeter.

The appliance of any preceding clause, wherein the outer wall is a woven fabric.

The appliance of any preceding clause, wherein the outer wall is a nylon mesh.

The appliance of any preceding clause, wherein the containment structure includes an outer wall defining a containment interior and the control unit is selectively received within the interior.

The appliance of any preceding clause, wherein the containment structure further comprises a closure selectively movable between an opened position and a closed position to provide selective access to the containment interior.

The appliance of any preceding clause, wherein the closure is a zipper.

The appliance of any preceding clause, wherein the at least one opening includes a first opening and a second opening, with the first opening corresponding to the at least one port.

The appliance of any preceding clause, further comprising a caddy having at least one projection selectively coupled to a corresponding portion of the housing of the control unit.

The appliance of any preceding clause, wherein the second opening is sized to accept the projection and form a seal around a respective portion of the projection when the projection is coupled to the housing.

The appliance of any preceding clause, wherein the seal forms a gap of less than or equal to 1 millimeter.

The appliance of any preceding clause, wherein the appliance is a one of a washing machine, a dishwasher, or an oven.

The appliance of any preceding clause, wherein the cabinet of the appliance includes a gravitational upper half and a gravitational lower half, and wherein the control unit is provided within the gravitational lower half.

The appliance of any preceding clause, wherein the containment structure is selectively receivable around the control unit.

The appliance of any preceding clause, wherein the control unit includes a thermal threshold of operation such that the control unit will fail if the threshold is surpassed, and wherein the containment structure includes a breathable material such that the thermal threshold is not reached during normal operation of the appliance.

## Claims

1. An appliance (10) comprising:
a cabinet (12) defining an interior (14);
a control unit (62) provided within the interior (14) and having at least one port (190) configured to receive a wire (188), and a housing defining a periphery of the control unit (62); and
a containment structure (176) provided around the periphery of the control unit (62), the containment structure (176) having at least one opening (184) corresponding to the at least one port (190);
wherein the at least one opening (184) is sized to accept the wire (188) and form a seal around a respective portion of the wire (188) when the wire (188) is received within the at least one port (190).

2. The appliance (10) of claim 1, wherein the containment structure (176) includes an outer wall (178) having a mesh or a net and defining an interior (180).

3. The appliance (10) of claim 2, wherein the mesh or the net is less than or equal to 1 millimeter.

4. The appliance (10) of claim 2 or claim 3, wherein the outer wall (178) is a woven fabric or a nylon mesh.

5. The appliance (10) of any one of the previous claims, wherein the containment structure (176) includes an outer wall (178) defining a containment interior (180), the control unit (62) being selectively received within the interior (180).

6. The appliance (10) of claim 5, wherein the containment structure (176) further comprises a closure (182) selectively movable between an opened position and a closed position to provide selective access to the containment interior (180), in particular wherein the closure (182) is a zipper.

7. The appliance (10) of any one of the previous claims, wherein the at least one opening (184) includes a first opening (184) and a second opening (184), with the first opening (184) corresponding to the at least one port (190).

8. The appliance (10) of claim 7, further comprising a caddy (192) having at least one projection (196) selectively coupled to a corresponding portion of the housing of the control unit (62), in particular wherein the second opening (184) is sized to accept the projection (196) and form a further seal around a respective portion of the projection (196) when the projection (196) is coupled to the housing.

9. The appliance (10) of any one of the previous claims, wherein the cabinet (12) of the appliance (10) includes a gravitational upper half (48) and a gravitational lower half (50), the control unit (62) being provided within the gravitational lower half (50).

10. The appliance (10) of any one of the previous claims, wherein the containment structure (176) is selectively receivable around the control unit (62).

11. The appliance (10) of any one of the previous claims, wherein the containment structure (176) is retrofittable to the appliance (10) and/or removable from the appliance (10).

12. The appliance (10) of any one of the previous claims, wherein the seal forms a gap of less than or equal to 1 millimeter.

13. The appliance (10) of any one of the previous claims, wherein the appliance (10) is a washing machine or a dishwasher or an oven.

14. The appliance (10) of any one of the previous claims, wherein the control unit (62) includes a thermal threshold of operation such that the control unit (62) will fail if the threshold is surpassed, the containment structure (176) including a breathable material such that the thermal threshold is not reached during normal operation of the appliance (10).

15. The appliance (10) of any one of the previous claims, wherein the containment structure (176), in particular the mesh or the net, is configured for preventing an insect, in particular a bug, from gaining access to the containment interior (180) and/or from reaching the control unit (62).
